# EUROPEAN PATENT SPECIFICATION

(11) **EP 3 916 496 B1**
(45) Date of publication and mention of the grant of the patent: **01.01.2025**
(21) Application number: 20177360.3
(22) Date of filing: 29.05.2020
(51) Int. Cl.: G05B 17/02

(54) **AN INDUSTRIAL PROCESS MODEL GENERATION SYSTEM**
SYSTEM ZUR ERZEUGUNG EINES INDUSTRIELLEN PROZESSMODELLS
SYSTÈME DE GÉNÉRATION D'UN MODÈLE DE PROCESSUS INDUSTRIEL

(43) Date of publication of application: 01.12.2021
(73) Proprietor: ABB Schweiz AG, 5400 Baden (CH)
(72) Inventor: JANKA, Dennis, 69121 Heidelberg (DE); KLOEPPER, Benjamin, 68199 Mannheim (DE); CHIOUA, Moncef, H2S0B6 Montreal (CA); RODRIGUEZ, Pablo, 69488 Birkenau (DE); LYMPEROPOULOS, Ioannis, 8953 Dietikon (CH); DIX, Marcel, 78476 Allensbach (DE)
(74) Representative: Maiwald GmbH

(56) References cited:
- EP-A2- 3 101 599
- US-A1- 2020 034 665
- US-A1- 2020 074 307

## Description

### FIELD OF THE INVENTION

The present invention relates to an industrial process model generation system, - and an industrial process model selection and generation method.

### BACKGROUND OF THE INVENTION

US2020/074307A1 describes systems and methods for performing at least one of assessing, optimizing and/or controlling the performance of an Anaerobic Digestion (AD) plant. The system comprises a server that provides a user interface for allowing a user to enter user inputs to define various aspects of the AD plant operation and to view results of the simulation; a database for storing the inputs used for the simulation of the anaerobic digestion plant, the inputs including feedstock inputs, AD operational inputs, and simulation criteria; and a simulation engine that can be operated in an at least one of an off-line simulation mode for generating off-line simulator predictions, a near-line simulation mode for optimizing the performance of the system and an online mode for using machine learning to tune the performance of various models used in simulating the operation of the AD plant.

US2020/034665A1 describes apparatuses, systems, program products, and methods for determining validity of machine learning algorithms for datasets. An apparatus includes a primary training module that is configured to train a first machine learning model for a first machine learning algorithm. An apparatus includes a primary validation module that is configured to validate a first machine learning model to generate an error data set. An apparatus includes a secondary training module that is configured to train a second machine learning model for a second machine learning algorithm using an error data set. A second machine learning algorithm may be configured to predict a suitability of a first machine learning model for analyzing an inference data set. An apparatus includes an action module that is configured to trigger an action in response to a predicted suitability of the first machine learning model not satisfying a predetermined suitability threshold.

EP3101599A2 describes machine learning systems and computerized methods to compare candidate machine learning algorithms. The machine learning system comprises a machine learning algorithm library, a data input module to receive a dataset and a selection of machine learning models derived from the machine learning algorithm library, an experiment module, and an aggregation module. The experiment module is configured to train and evaluate each machine learning model to produce a performance result for each machine learning model. The aggregation module is configured to aggregate the performance results for all of the machine learning models to form performance comparison statistics. Computerized methods include receiving a dataset, receiving a selection of machine learning models, training and evaluating each machine learning model to produce a performance result for each machine learning model, aggregating the performance results to form performance comparison statistics, and presenting the performance comparison statistics.

Industrial application of machine learning usually suffers from the availability of sufficient (labeled) training data for the training of machine learning models. High fidelity simulators can be used to generate additional data to improve the quality of such machine learning models. However, running high fidelity simulations is time-consuming and computationally expensive. Blind generation of data is very expensive and does not have a guaranteed impact on the performance of the machine learning algorithm.

There is a need to improve model development for industrial processes

### SUMMARY OF THE INVENTION

Therefore, it would be advantageous to have an improved technique to generate models for industrial processes.

The object of the present invention is solved with the subject matter of the independent claims, wherein further embodiments are incorporated in the dependent claims.

The invention and its scope of protection is defined in the independent claims. An industrial process model generation system is defined in claim 1, and an industrial process model selection and generation method is defined in claim 8. The following aspects and examples provide the skilled person with examples of how subject matters can be combined.

In a first aspect, there is provided an industrial process model generation system, comprising:
- an input unit; and
- a processing unit.

The input unit is configured to receive a plurality of input value trajectories comprising operational input value trajectories and simulation input value trajectories relating to an industrial process. The processing unit is configured to implement a simulator of the industrial process. The processing unit is configured to generate a plurality of industrial process behavioural data. Industrial process behavioural data is generated for at least some of the plurality of input value trajectories, and the generation of the industrial process behavioural data for the at least some of the plurality of input value trajectories comprises utilization of the simulator. The processing unit is configured to implement a machine learning algorithm that models the industrial process. The processing unit is configured to train the machine learning algorithm. The processing unit is configured to process a first behavioural data of the plurality of behavioural data with the machine learning algorithm to determine a first modelled result. The processing unit is configured to determine to train or not to train the machine learning algorithm using the first behavioural data, the determination comprising a comparison of the first modelled result with a performance condition. The processing unit is configured to process a second behavioural data of the plurality of behavioural data with the machine learning algorithm to determine a second modelled result. The processing unit is configured to determine to train or not to train the machine learning algorithm using the second behavioural data or to further train or not to further train the machine learning algorithm using the second behavioural data, the determination comprising a comparison of the second modelled result with the performance condition.

The input value trajectories are real input data or simulated input data.

Thus, a set of industrial process behavioural data is produced by the simulator based on input value trajectories that can be real values or simulated , and a machine learning algorithm is trained on subsets of this data, with the system deciding which subsets of the data to actually use in that training.

The machine learning algorithm can be trained on "real" industrial process behavioural data in addition to that generated by the simulator, in that the plurality of industrial process behavioural data can then comprise that generated by the simulator and the "real" data. However, all of the plurality of indcutrial process behavioural data can be that as generated by the simulator.

In this way, as new input trajectories are provided, that are real input data or simulated input data, associated behavioural data generated from a simulator can be used to train a machine learning model or not to train the machine learning model of the industrial process. This continues stepwise as behavioural data is generated, where the machine learning algorithm is continually trained with appropriate data but not trained with data that is not appropriate.

The operational input value trajectories are any inputs a plant operator would make to the production process. These are for example setpoints (target values for automation/control loop(s)), parameters for actuators (for example a percentage opening or closing of a valve) and digital inputs (pump on/off).

In addition to inputs an operator would make (operational input value trajectories), there are also inputs to configure and control the simulation. Examples are the initial plant state at the beginning of the simulation, raw-material composition/quality, simulation of failures at certain types (e.g. valve failures (leakage, sticking etc), rotating equipment failures (pumps, compressors) etc. These are termed simulation input value trajectories.

Thus, input value trajectories are inputs that control (feed-forward) the simulation process, and the simulator can produce industrial process behavioural data that comprises for example one or more of: process data (e.g. simulated temperature, pressure, level, flow values), actuator data (simulated valve positions, heat exchanger inflow, motor currents etc), setpoints (e.g. target values for PID ((proportional integral derivative) controller).

It is to be noted that "a processor" and "the processor" does not mean that system must use only one processor. For example a processor can implement the simulator to produce data and a second processor implement the machine learning algorithm.

In an example, the plurality of behavioural datas comprises one or more of: process data; temperature data; pressure data; flow data; level data; voltage data; current data; power data; actuator data; valve data; sensor data; controller data.

Thus, input value trajectories are inputs that control (feed-forward) the simulation process, and the simulator can produce industrial process behavioural data that comprises for example one or more of: initial simulation state (e.g. simulated temperature, pressure, level, flow values), actuator data (simulated valve positions, heat exchanger inflow, motor currents etc), setpoints (e.g. target values for PID ((proportional integral derivative) controller).

In an example, the modelled result comprises a control or monitoring output of the industrial process.

Thus, the machine learning algorithm is trained to produce a machine learning model that for example realizes a task control or monitors the actual industrial process that is simulated.

The processing unit is configured to select the at least some of the plurality of input value trajectories.

Thus, the system can select or decide on which input value trajectorties are to be provided to the simulator to generate new behavioral data that could be used for training, which optimizes computational efficiency as the simulator may not need to be invoked.

The selection of the at least some of the plurality of input value trajectories comprises utilization of a determined sensitivity of the trained machine learning algorithm to at least a portion of the plurality of behavioural data.

In an example, the determination to train or not to train the machine learning algorithm using the first behavioural data, comprises a determination of a sensitivity of the trained machine learning algorithm to at least a portion of the plurality of behavioural data.

In an example, the determination to train or not to train the machine learning algorithm using the second behavioural data, comprises a determination of the sensitivity of the trained machine learning algorithm to at least a portion of the plurality of behavioural data.

In an example, the determination to further train or not to further train the machine learning algorithm using the second behavioural data, comprises a determination of the sensitivity of the trained machine learning algorithm to at least a portion of the plurality of behavioural data.

In an example, the determination of the sensitivity of the trained machine learning algorithm to at least the portion of the plurality of behavioural data comprises an analysis of a loss function of the trained machine learning algorithm with respect to at least the portion of the plurality of behavioural data.

In an example, the processing unit is configured to determine to stop training of the machine learning algorithm, the determination comprising a determination of a sensitivity of the trained machine learning algorithm to at least a portion of the plurality of behavioural data.

Thus, the machine learning algorithm (model) is analyzed to identify which operational input trajectories and simulation input value trajectories should be used for generating new behavioural data for training of the machine learning algorithm in order so that the newly generated simulated data will significantly change the machine learning model "a lot" as the machine learning algorithms is trained (additionally) on the new data. And, when the machine learning algorithm is not being significantly changed, the training can be stopped and a final trained machine learning algorithm can be provided to model the process.

In a second aspect, there is provided an industrial process model generation method, comprising:
receiving a plurality of input value trajectories comprising operational input value trajectories and simulation input value trajectories relating to an industrial process;
implementing by a processing unit a simulator of the industrial process;
generating by the processing unit a plurality of industrial process behavioural data, wherein the industrial process behavioural data is generated for at least some of the plurality of input value trajectories, and wherein the generation of the industrial process behavioural data for the at least some of the plurality of input value trajectories comprises utilization of the simulator;
implementing by the processing unit a machine learning algorithm that models the industrial process, wherein the processing unit is configured to train the machine learning algorithm;
processing by the processing unit a first behavioural data of the plurality of behavioural data with the machine learning algorithm to determine a first modelled result;
determining by the processing unit to train or not to train the machine learning algorithm using the first behavioural data, the determination comprising a comparison of the first modelled result with a performance condition;
processing by the processing unit a second behavioural data of the plurality of behavioural data with the machine learning algorithm to determine a second modelled result;
determining by the processing unit to train or not to train the machine learning algorithm using the second behavioural data or to further train or not to further train the machine learning algorithm using the second behavioural data, the determination comprising a comparison of the second modelled result with the performance condition.

The method comprises selecting by the processing unit the at least some of the plurality of input value trajectories.

The selecting of the at least some of the plurality of input value trajectories comprises utilizimng a determined sensitivity of the trained machine learning algorithm to at least a portion of the plurality of behavioural data.

In an example, the determining to train or not to train the machine learning algorithm using the first behavioural data, comprises determining a sensitivity of the trained machine learning algorithm to at least a portion of the plurality of behavioural data.

In an example, the determining to train or not to train the machine learning algorithm using the second behavioural data, comprises determining the sensitivity of the trained machine learning algorithm to at least a portion of the plurality of behavioural data.

In an example, the determining to further train or not to further train the machine learning algorithm using the second behavioural data, comprises determining the sensitivity of the trained machine learning algorithm to at least a portion of the plurality of behavioural data.

In an example, the determining the sensitivity of the trained machine learning algorithm to at least the portion of the plurality of behavioural data comprises analysing a loss function of the trained machine learning algorithm with respect to at least the portion of the plurality of behavioural data.

In an example, method comprises determining by the processing unit to stop training the machine learning algorithm, the determining comprising determining a sensitivity of the trained machine learning algorithm to at least a portion of the plurality of behavioural data.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an overview workflow of a new process of model training and training data generation;
Fig. 2 shows an overview workflow of a new process of searching for a suitable model architecture - i.e., for a suitable machine learning algorithm;
Fig.3 shows a detailed workflow of a standard process of model training and training data generation;
Fig. 4 shows a detailed workflow of a new process of model training and training data generation; and
Fig. 5 shows a detailed workflow of a new process of searching for a suitable model architecture.

### DETAILED DESCRIPTION OF EMBODIMENTS

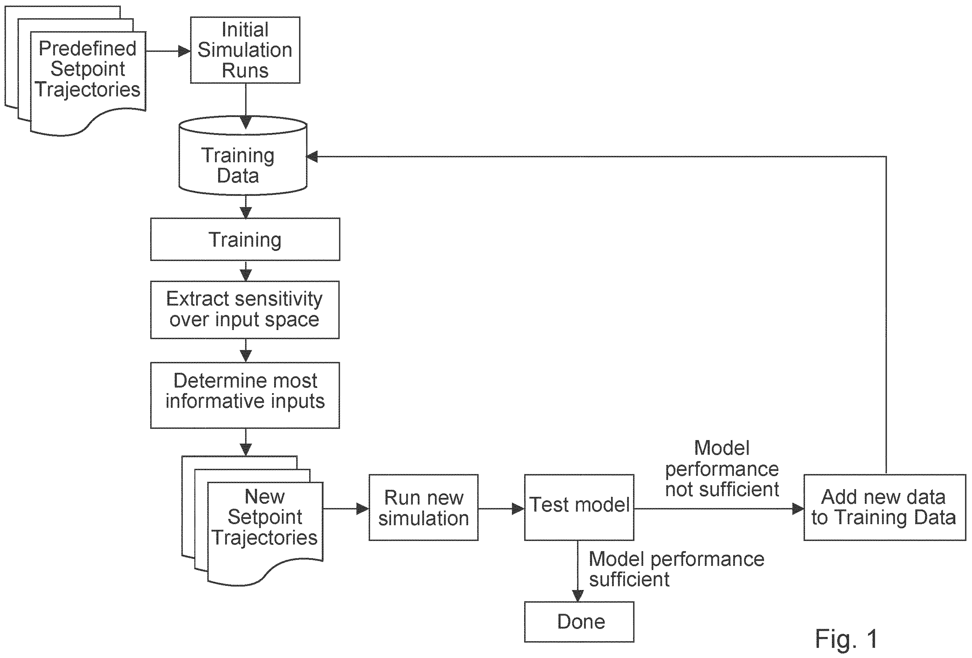

Figs. 1-5 relate to an industrial process model generation system, an industrial process model selection and generation system, an industrial process model generation method, and an industrial process model selection and generation method.

### An industrial process model generation system

An example of an industrial process model generation system comprises an input unit, and a processing unit. The input unit is configured to receive a plurality of input value trajectories comprising operational input value trajectories and simulation input value trajectories relating to an industrial process. The processing unit is configured to implement a simulator of the industrial process. The processing unit is configured to generate a plurality of industrial process behavioural data. Industrial process behavioural data is generated for the plurality of input value trajectories, and the generation of the industrial process behavioural data for the plurality of input value trajectories comprises utilization of the simulator. The processing unit is configured to implement a machine learning algorithm that models the industrial process. The processing unit is configured to train the machine learning algorithm. The processing unit is configured to process a first behavioural data of the plurality of behavioural data with the machine learning algorithm to determine a first modelled result. The processing unit is configured to determine to train or not to train the machine learning algorithm using the first behavioural data, the determination comprising a comparison of the first modelled result with a performance condition. The processing unit is configured to process a second behavioural data of the plurality of behavioural data with the machine learning algorithm to determine a second modelled result. The processing unit is configured to determine to train or not to train the machine learning algorithm using the second behavioural data or to further train or not to further train the machine learning algorithm using the second behavioural data, the determination comprising a comparison of the second modelled result with the performance condition.

In other words, it can be determined that the machine learning algorithm can be improved by further training it with generated data, or determined that the machine learning model need not be improved with that generated data.

In an example, the performance condition comprises one or more of: a target accuracy, target false positive rates, target false negative rates.

According to an example, the plurality of input value trajectories comprises one or more of: process data; temperature data; pressure data; flow data; level data; voltage data; current data; power data; actuator data; valve data; sensor data; controller data.

According to an example, the modelled result comprises a control or monitoring output of the industrial process.

According to an example, the processing unit is configured to select the at least some of the plurality of input value trajectories.

In an example, the selection of the at least some of the plurality of input value trajectories comprises utilization of a determined sensitivity of the trained machine learning algorithm to at least a portion of the plurality of behavioural data.

According to an example, the determination to train or not to train the machine learning algorithm using the first behavioural data, comprises a determination of a sensitivity of the trained machine learning algorithm to at least a portion of the plurality of behavioural data.

According to an example, the determination to train or not to train the machine learning algorithm using the second behavioural data, comprises a determination of the sensitivity of the trained machine learning algorithm to at least a portion of the plurality of behavioural data.

According to an example, the determination to further train or not to further train the machine learning algorithm using the second behavioural data, comprises a determination of the sensitivity of the trained machine learning algorithm to at least a portion of the plurality of behavioural data.

According to an example, the determination of the sensitivity of the trained machine learning algorithm to the plurality of behavioural data comprises an analysis of a loss function of the trained machine learning algorithm with respect to at least the portion of the plurality of behavioural data.

According to an example, the processing unit is configured to determine to stop training of the machine learning algorithm, the determination comprising a determination of a sensitivity of the trained machine learning algorithm to at least a portion of the plurality of behavioural data.

### An industrial process model selection and generation system

An example of an industrial process model selection and generation system comprises an input unit, and a processing unit. The input unit is configured to receive a plurality of input value trajectories comprising operational input value trajectories and simulation input value trajectories. The processing unit is configured to implement a simulator of the industrial process. The processing unit is configured to generate a plurality of industrial process behavioural data. Industrial process behavioural data is generated for the plurality of input value trajectories, and the generation of the industrial process behavioural data for the plurality of input value trajectories comprises utilization of the simulator. The processing unit is configured to implement a plurality of machine learning algorithm that model the industrial process. The processing unit is configured to process a first behavioural data of the plurality of behavioural data with a first machine learning algorithm of the plurality of machine learning algorithms to determine a first machine learning algorithm first modelled result. The processing unit is configured to determine to train the first machine learning algorithm using the first behavioural data or implement a second machine learning algorithm of the plurality of machine learning algorithms, the determination comprising a comparison of the first machine learning algorithm first modelled result with a performance condition.

In this way, the best machine learning algorithm to be used for process monitoring can be selected and trained.

In an example, the performance condition comprises one or more of: a target accuracy, target false positive rates, target false negative rates.

According to an example, the processing unit is configured to process a second behavioural data of the plurality of behavioural data with the first machine learning algorithm to determine a first machine learning algorithm second modelled result. The processing unit is configured to determine to train the first machine learning algorithm using the second behavioural data or implement the second machine learning algorithm, the determination comprising a comparison of the first machine learning algorithm second modelled result with the performance condition.

According to an example, the processing unit is configured to process the first behavioural data with the second machine learning algorithm to determine a second machine learning algorithm first modelled result. The processing unit is configured to determine to train the second machine learning algorithm using the first behavioural data or implement a third machine learning algorithm of the plurality of machine learning algorithms, the determination comprising a comparison of the second machine learning algorithm first modelled result with the performance condition.

According to an example, the processing unit is configured to select the at least some of the plurality of input value trajectories.

In an example, the selection of the at least some of the plurality of input value trajectories comprises utilization of a determined sensitivity of the trained machine learning algorithm to at least a portion of the plurality of behavioural data.

According to an example, the determination to train the existing machine learning algorithm using behavioural data or implement a new machine learning algorithm, comprises a determination of a sensitivity of the existing trained machine learning algorithm to at least a portion of the plurality of behavioural data.

According to an example, the processing unit is configured to determine to stop training of the existing machine learning algorithm, the determination comprising a determination of the sensitivity of the trained machine learning algorithm to at least a portion of the plurality of behavioural data.

According to an example, the determination of the sensitivity of the trained machine learning algorithm to at least the portion of the plurality of behavioural data comprises an analysis of a loss function of the trained machine learning algorithm with respect to at least the portion of the plurality of behavioural data.

According to an example, the first machine learning algorithm is a simplest machine learning algorithm of the plurality of machine learning algorithms.

According to an example, the second machine learning algorithm is a second moat simplest machine learning algorithm of the plurality of machine learning algorithms.

According to an example, the third machine learning algorithm is a third most simplest machine learning algorithm of the plurality of machine learning algorithms.

### An industrial process model generation method

An example of an industrial process model generation method comprises:
receiving a plurality of input value trajectories comprising operational input value trajectories and simulation input value trajectories relating to an industrial process;
implementing by a processing unit a simulator of the industrial process;
generating by the processing unit a plurality of industrial process behavioural data, wherein the industrial process behavioural data is generated for the plurality of input value trajectories, and wherein the generation of the industrial process behavioural data for the plurality of input value trajectories comprises utilization of the simulator;
implementing by the processing unit a machine learning algorithm that models the industrial process, wherein the processing unit is configured to train the machine learning algorithm;
processing by the processing unit a first behavioural data of the plurality of behavioural data with the machine learning algorithm to determine a first modelled result;
determining by the processing unit to train or not to train the machine learning algorithm using the first behavioural data, the determination comprising a comparison of the first modelled result with a performance condition;
processing by the processing unit a second behavioural data of the plurality of behavioural data with the machine learning algorithm to determine a second modelled result; and
determining by the processing unit to train or not to train the machine learning algorithm using the second behavioural data or to further train or not to further train the machine learning algorithm using the second behavioural data, the determination comprising a comparison of the second modelled result with the performance condition.

In an example, the determining to train or not to train the machine learning algorithm using the first behavioural data, comprises determining a sensitivity of the trained machine learning algorithm to at least a portion of the plurality of behavioural data.

In an example, the determining to train or not to train the machine learning algorithm using the second behavioural data, comprises determining the sensitivity of the trained machine learning algorithm to at least a portion of the plurality of behavioural data.

In an example, the determining to further train or not to further train the machine learning algorithm using the second behavioural data, comprises determining the sensitivity of the trained machine learning algorithm to at least a portion of the plurality of behavioural data.

In an example, the determining the sensitivity of the trained machine learning algorithm to the plurality of behavioural data comprises analysing a loss function of the trained machine learning algorithm with respect to at least the portion of the plurality of behavioural data.

In an example, method comprises determining by the processing unit to stop training the machine learning algorithm, the determining comprising determining a sensitivity of the trained machine learning algorithm to at least a portion of the plurality of behavioural data.

In an example, the method comprises selecting by the processing unit the at least some of the plurality of input value trajectories.

In an example, the selecting of the at least some of the plurality of input value trajectories comprises utilizimng a determined sensitivity of the trained machine learning algorithm to at least a portion of the plurality of behavioural data.

### An industrial process model selection and generation method

An example of an industrial process model selection and generation method comprises:
receiving a plurality of input value trajectories comprising operational input value trajectories and simulation input value trajectories relating to an industrial process;
implementing by a processing unit a simulator of the industrial process;
generating by the processing unit a plurality of industrial process behavioural data, wherein the industrial process behavioural data is generated for the plurality of input value trajectories, and wherein the generation of the industrial process behavioural data for the plurality of input value trajectories comprises utilization of the simulator;
implementing by the processing unit a first machine learning algorithm of a plurality of machine learning algorithms that model the industrial process;
processing by the processing unit a first behavioural data of the plurality of behavioural data with the first machine learning algorithm of the plurality of machine learning algorithms to determine a first machine learning algorithm first modelled result; and
determining by the processing unit to train the first machine learning algorithm using the first behavioural data or implement a second machine learning algorithm of the plurality of machine learning algorithms, the determination comprising a comparison of the first machine learning algorithm first modelled result with a performance condition.

In an example, the method comprises processing by the processing unit a second behavioural data of the plurality of behavioural data with the first machine learning algorithm to determine a first machine learning algorithm second modelled result; and determining by the processing unit to train the first machine learning algorithm using the second behavioural data or implement the second machine learning algorithm, the determination comprising a comparison of the first machine learning algorithm second modelled result with the performance condition.

In an example, method comprises processing with the processing unit the first behavioural data with the second machine learning algorithm to determine a second machine learning algorithm first modelled result; and determining by the processing unit to train the second machine learning algorithm using the first behavioural data or implement a third machine learning algorithm of the plurality of machine learning algorithms, the determination comprising a comparison of the second machine learning algorithm first modelled result with the performance condition.

In an example, the method comprises selecting by the processing unit the at least some of the plurality of input value trajectories.

In an example, the selecting of the at least some of the plurality of input value trajectories comprises utilizimng a determined sensitivity of the trained machine learning algorithm to at least a portion of the plurality of behavioural data.

In an example, determining to train the existing machine learning algorithm using behavioural data or implement a new machine learning algorithm, comprises a determination of a sensitivity of the existing trained machine learning algorithm to at least a portion of the plurality of behavioural data.

In an example, the processing unit is configured to determine to stop training of the existing machine learning algorithm, the determination comprising a determination of the sensitivity of the trained machine learning algorithm to at least a portion of the plurality of behavioural data.

In an example, the determination of the sensitivity of the trained machine learning algorithm to at least the portion of the plurality of behavioural data comprises an analysis of a loss function of the trained machine learning algorithm with respect to at least the portion of the plurality of behavioural data.

The industrial process training data generation system, industrial process monitoring systems, the method of generating industrial process training data, and the industrial process monitoring methods are now described in further detail with respect to specific detailed embodiments, where reference is again made to Figs. 1-2.

Fig. 1 shows an overview of the integrated workflow of model training and training data generation using high fidelity simulators.

To begin with there are a number of predefined operator input value trajectories and disturbance trajectories, e.g. a set of step changes on the relevant setpoints of the process or activation or deactivation of actuator failures like valve failures. The operator input value trajectories and disturbance trajectories can be for simplicity be termed together as input value trajectories. Such step change experiments are well known from system identification. With the input value trajectories and the disturbance trajectories, labels can be created along with the simulation data. Data from the introduction of a disturbance in the simulation is labeled as abnormal or failure. In case of system identification tasks, the data after a setpoint change (response) serve as label information for the machine learning process.

These input value trajectories are used to control the process in a number of simulation runs. One simulation run captures the system behavior and response to one input value trajectory. At the end of these simulation runs, the initial training data set has been created.

In the next step, a machine learning algorithm (here algorithm could mean more than one algorithm running together) is trained by being presented the training data changing the parameters of the underlying model (It has been established that the machine learning algorithm can be based on deep learning network, linear regression, random forest, SVM, etc.) based on a loss function. At the end of this step, the first model has been trained. During this step, the training data set can be split into a training data set and a test (hold out) data set. Furthermore, the training data set can be repeatedly split into a training and validation data set (cross validation).

In the next step, the system extracts the sensitivity of the machine learning algorithm(s) towards the entire space of possible inputs to the algorithm(s). One way is to analyze the loss function (a measure of the models prediction error) of the model in both the training set or validation set samples. However, it is known how this can be carried out in other ways.

Based on additional constraints (e.g. min and max values of the setpoints, or thresholds of system trips) the most informative new inputs are generated. When using existing samples in the training or validation data set, the new inputs can be generated creating input value trajectories in the neighborhood of the original data points.

The new setpoint and disturbance trajectories (input value trajectories) are used as inputs for new simulation runs. These runs create new data points. First, the existing model is tested on the new data points. If the performance is good enough (e.g. based on a target accuracy, or target false positives/false negative rates), the process finishes and the created machine learning model can be used online.

If the model is not good enough, the new data points are added to training data set and the machine learning model is retrained in order to improve it.

In a variant of the above process more than a single machine learning model can be trained, but a group of machine learning algorithms or models can be trained. The most informative points are then a mixture of the most informative points across all models. Models that keep producing significantly poorer results (e.g. based on a statistical test) then other models can be excluded from the process.

In another variant of the above sketched process the training data set also contains historical data from an actual plant for the initial training.

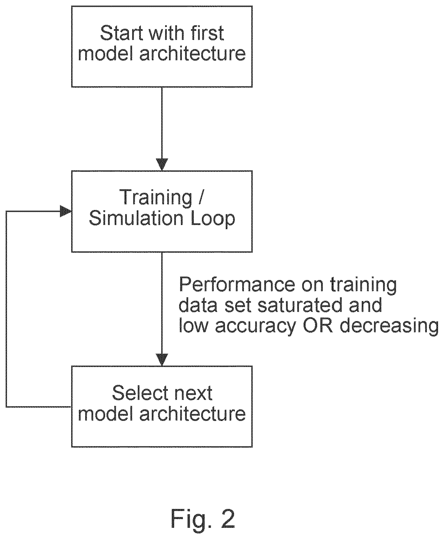

Fig. 2 shows an external process to the process sketched in Fig. 1. Here a search process starts from a very simple machine learning model (e.g. a logistic regression or an artificial neural network with few layers). When the model performance saturates on a poor accuracy (or some other performance measure) or even starts decreasing while being presented more informative data, the search process changes to a more complex model - either by a predefined list of machine learning models or by adding additional degree of freedoms to the model architecture, e.g. by adding layers. Also a combination of the two methods is possible - first increase the complexity of a given class of e.g. deep learning networks and then change to a more complex network architecture.

As detailed in the above, a workflow has been developed in which the machine learning model or its performance on individual samples in the training or validation data set are used to determine new simulation inputs, that would result in simulation runs highly informative for the machine learning model. The new data is generated with the simulation system. The already trained algorithm(s) is tested on the new, never seen data. If the performance of the algorithm is sufficient, the process stops. If the performance is not sufficient, the new data is added to training data and the machine learning model is retrained and the process continues.

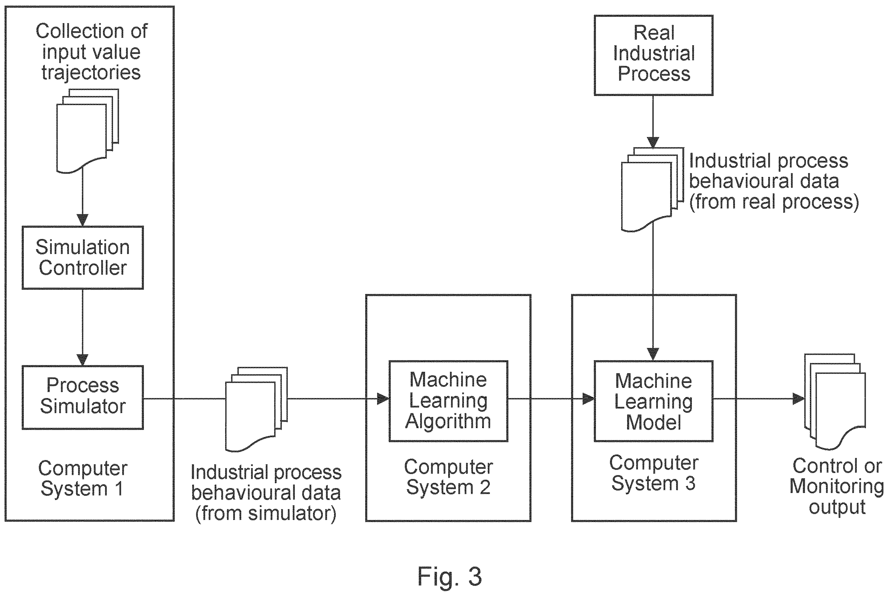

To further explain the industrial process model generation system, industrial process model selection and generation system and associated methods, reference is made to Figs. 3-5.

Fig. 3 shows a detailed example of an existing simulation workflow.

The simulation of the industrial process takes two types of inputs: [1] inputs as the operator of the process would make and [2] inputs that are only possible in the simulation and in reality are outside of the control of an operator, e.g. equipment failures, raw material quality, outside temperature etc.

To generate data to train a machine learning model, trajectories of these inputs need to be defined to control the simulation. The trajectories define for example that "at minute 5, the operator opens a valve" and "at minute 20 the valve starts leaking 50% of the flow"

The output of the process simulator are all the values usually available in a process control system (setpoints, sensor readings, actuator values like valve positions).

This method is used to train machine learning algorithms, for example, to (1) detect process anomalies, (2) detect device failures, (3) predict the future behaviour of the process, and (4) select the best possible next controller output

The output of the training is a model that can be fed with new and previously unseen data and can perform for example can perform one of the task (1)-(4)

The model is connected to the real industrial process (which produces the same types of data points as the simulator version) and will perform the task and generate the corresponding output.

In this flow, a human would define the input trajectories, review the result of the ML algorithms (the performance of the model) and decide what input value trajectories to use in the next iteration.

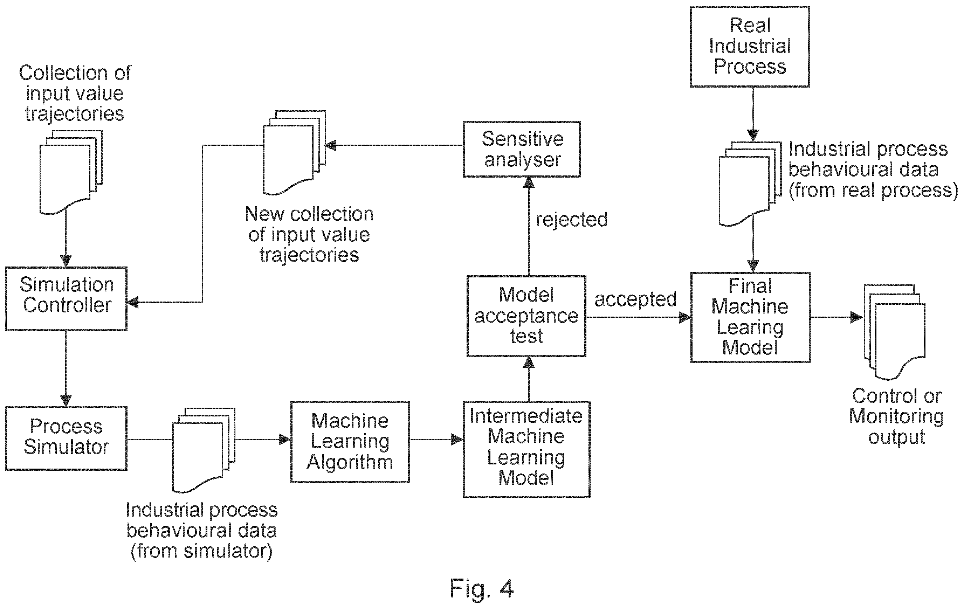

Fig. 4 shows a detailed example of a development made by the inventors.

In essence the new development is to analyze the model that is generated by the machine learning algorithms in order to find out, which new data will yield the best improvement of the generated model.

If the model is good enough for usage in the real process, no new data will be generated and the model will be used.

In this flow, the system or method test the model, analyzes the model and decides what new input value trajectories are used in the next iteration.

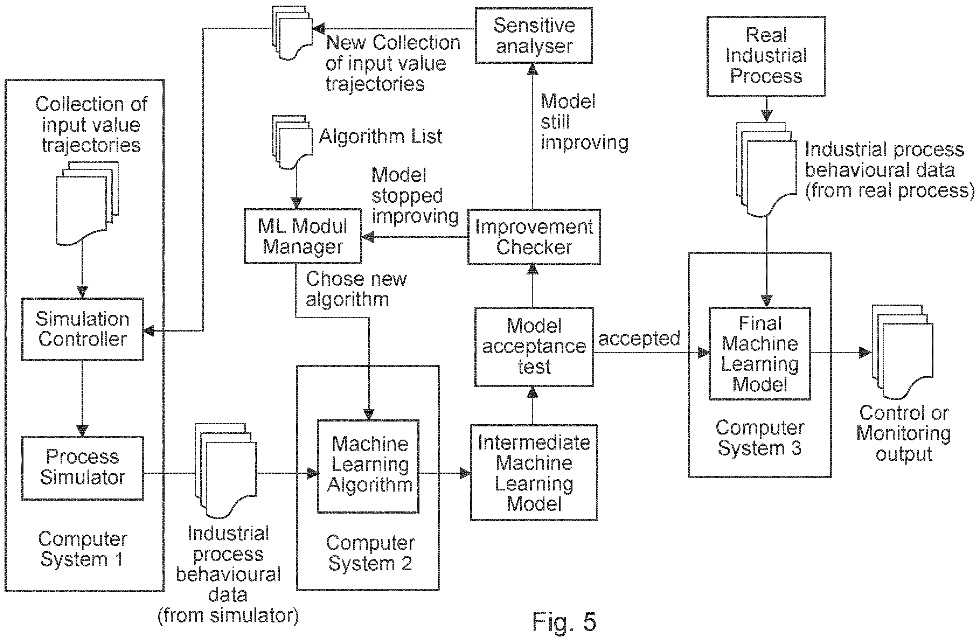

Fig. 5 shows a detailed example of a further development made by the inventors. The extension relates to the introduction of another loop besides the repeated data generation and training.

After the model acceptance check, the improvement checker tests if the model is still improving by adding new data to the data set. This can be done either by directly analyzing the sensitivity of the model on the input (if the sensitivity is low across all inputs, the model cannot be much further improved) or by simply tracking if the model has seen an improvement above a threshold value in the last n versions. The performance is measured by some performance measure like the F1 Score (for classification) or the RMSE (root mean-squared error) (for regression).

If the model is not improving anymore (and will not improve based on the output of the sensitivity layer) a model manager maintains a list of algorithms, starting from the simplest ML algorithms (e.g. linear regression (regression) or logistic regression (classification) towards more complex algorithms (e.g. Support Vector Machines and Deep Learning Artificial Neural Networks). Each time the ML model stopped improving the next more complex model is chosen and the training starts again - always starting all the training data available at that time.

Complexity for artificial neural networks is determined by the complexity of the architecture, e.g. measured by number of hidden layers and number of nodes in the hidden layer.

In this flow, the system or method still tests the model, analyzes the model and decides what new input value trajectories are used in the next iteration. In addition, the system or method decides if the currently used machine learning algorithms can still be improved and might achieve the required performance or if a more complex algorithm should be used.

Note: One does not use the most complex algorithm at the beginning, because it might "overfit" the training data (basically creates a look-up-table for the training data) and will not be able to generalizes towards data outside the training data set.

In Figs. 3-5, it is shown that different computers, or processing units of such computers, can carry out different functions. This can be the case, but also a single processing unit can carry out all the different functions if required.

### Sensitivity analysis

Regarding analysing the sensitivity of the machine learning algorithm or model, the following are three examples relating to this:
One example of analyzing the sensitivity of the machine learning model is to select the *n* industrial process behavioural data for which the machine learning model differs most from the actual value (the difference is also called the prediction error). To generate the input value trajectories that will help the model to improve, the *n* input value trajectories that were used to generate the *n* industrial process behavioural with largest prediction error are varied, e.g. by randomly changing the initial state of the simulation or changing randomly some of the input values within the input value trajectory.

In another example, another machine learning model algorithm is trained to predict the prediction error of the first machine algorithm using the initial state and other characteristic of the input value trajectory as predictor variables. This machine learning model can be for instance a decision tree, which will return a sequence of decision which input value trajectory values will yield a poor prediction on the current machine learning model. This information can be used to generate new input value trajectories with exactly these content, for instance specific initial states for simulation, specific types of operator inputs (e.g. setpoint changes, manual actuator changes) and parameters of these inputs (e.g. initial setpoint and new setpoint), or failure types.

In another example specific for artificial neural networks, new high-information data points are generated as follows: An optimization algorithm (such as genetic algorithms, a reinforcement learning algorithms, or a Bayesian optimization algorithms) produces input values trajectories that are used to produce behavioral data using the process simulation system. For each behavioral data, the derivative (i.e., the sensitivity) of the neural network prediction (model response) with respect to the model parameters can be evaluated without the need to undergo an entire training and validation cycle. This means that this gradient information can be evaluated for a large number of candidate points in a short amount of time. The resulting points are "high-information" points in the following sense:
During subsequent training, a gradient-descent type algorithm will take large steps towards a better solution in case the prediction error is high, i.e., if the model can be improved.
During subsequent training, a gradient-descent type algorithm will stay in the vicinity of its current solution in case the prediction error is low, i.e., if the model generalizes well to the newly found input trajectories.

Therefore, input trajectories that have maximized sensitivity of the model response will either cause the model to improve or validate the current model. In special cases, when the input to artificial neural network (the predictor variables) only contain information that is part of the input value trajectory and the output of the process simulation (the process behavioural data) is part of the output (predicted value) the step of process simulation can be avoided and a large number of candidate input value trajectory can be directly evaluated using the derivative of the neural network prediction (model response) with respect to the model parameters. In this case, the time to evaluate candidate input trajectories is even shorter.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

## Claims

1. An industrial process model generation system, comprising:
- an input unit; and
- a processing unit;
wherein, the input unit is configured to receive a plurality of input value trajectories comprising real input data and/or simulated input data relating to an industrial process, and wherein the input value trajectories are used to control the industrial process in a number of simulation runs to generate an initial training data set;
wherein, the processing unit is configured to implement a simulator of the industrial process;
wherein, the processing unit is configured to implement a machine learning algorithm that models the industrial process;
wherein, the processing unit is configured to train the machine learning algorithm comprising utilization of the initial training data set;
wherein, the processing unit is configured to utilize the
simulator to generate a plurality of industrial process behavioural data, wherein industrial process behavioural data is generated for at least some of the plurality of input value trajectories, wherein the processing unit is configured to select the at least some of the plurality of input value trajectories, wherein the selection of the at least some of the plurality of input value trajectories comprises utilization of a determined sensitivity of the machine learning algorithm to at least a portion of the plurality of behavioural data, , and wherein the industrial process behavioural data comprises one or more of; process data, actuator data, and setpoints;
wherein the processing unit is configured to train the machine learning algorithm in a stepwise process comprising:
as part of the stepwise process the processing unit is configured to process a first behavioural data of the plurality of behavioural data with the machine learning algorithm to determine a first modelled result; as part of the stepwise processthe processing unit is configured to determine to train or not to train the machine learning algorithm using the first behavioural data, the determination comprising a comparison of the first modelled result with a performance condition;
as part of the stepwise processthe processing unit is configured to process a second behavioural data of the plurality of behavioural data with the machine learning algorithm to determine a second modelled result;
as part of the stepwise process after the determination to train or not to train the machine learning algorithm using the first behavioural data the processing unit is configured to determine to train or not to train the machine learning algorithm using the second behavioural data, the determination comprising a comparison of the second modelled result with the performance condition; and
as part of the stepwise process the processing unit is configured to continue to train the machine learning algorithm with behavioural data and associated modelled results until the machine learning algorithm has not been significantly changed in the last step of training, and wherein when the training has stopped a final trained machine learning algorithm is provided; and
wherein the final trained machine learning algorithm is configured to be fed with new data to perform one or more of: (1) detect process anomalies, (2) detect device failures, (3) predict the future behaviour of the process, and (4) select the best possible next controller output.

2. System according to claim 1, wherein the plurality of input value trajectories comprises one or more of: process data; temperature data; pressure data; flow data; level data; voltage data; current data; power data; actuator data; valve data; sensor data; controller data.

3. System according to any of claims 1-2, wherein the determination to train or not to train the machine learning algorithm using the first behavioural data, comprises a determination of a sensitivity of the trained machine learning algorithm to at least a portion of the plurality of behavioural data.

4. System according to any of claims 1-3, wherein the determination to train or not to train the machine learning algorithm using the second behavioural data, comprises a determination of the sensitivity of the trained machine learning algorithm to at least a portion of the plurality of behavioural data.

5. System according to any of claims 1-4, wherein the determination to further train or not to further train the machine learning algorithm using the second behavioural data, comprises a determination of the sensitivity of the trained machine learning algorithm to at least a portion of the plurality of behavioural data.

6. System according to any of claims 4-5, wherein the determination of the sensitivity of the trained machine learning algorithm to at least a portion of the plurality of behavioural data comprises an analysis of a loss function of the trained machine learning algorithm with respect to at least the portion of the plurality of behavioural data.

7. System according to any of claims 1-6, wherein the processing unit is configured to determine to stop training of the machine learning algorithm, the determination comprising a determination of a sensitivity of the trained machine learning algorithm to at least a portion of the plurality of behavioural data.

8. An industrial process model generation method, comprising:
receiving a plurality of input value trajectories comprising real input data and/or simulated input datarelating to an industrial process, and wherein the input value trajectories are used to control the industrial process in a number of simulation runs to generate an initial training data set;
implementing by a processing unit a simulator of the industrial process;
implementing by the processing unit a machine learning algorithm that models the industrial process;
training by the processing unit the machine learning algorithm comprising utilizing the initial training data set;
generating by the processing unit a plurality of industrial process behavioural data, wherein the industrial process behavioural data is generated for at least some of the plurality of input value trajectories, wherein the processing unit selects the at least some of the plurality of input value trajectories, wherein the selecting of the at least some of the plurality of input value trajectories comprises utilizing a determined sensitivity of the machine learning algorithm to at least a portion of the plurality of behavioural data,, and wherein the industrial process behavioural data comprises one or more of; process data, actuator data, and setpoints;
training by the processing unit the machine learning algorithm in a stepwise process comprising: as part of the stepwise process processing by the processing unit a first behavioural data of the plurality of behavioural data with the machine learning algorithm to determine a first modelled result;
as part of the stepwise process determining by the processing unit to train or not to train the machine learning algorithm using the first behavioural data, the determination comprising a comparison of the first modelled result with a performance condition;
as part of the stepwise process processing by the processing unit a second behavioural data of the plurality of behavioural data with the machine learning algorithm to determine a second modelled result;
as part of the stepwise processafter the determining to train or not to train the machine learning algorithm using the first behavioural data tdetermining by the processing unit to train or not to train the machine learning algorithm using the second behavioural data, the determining comprising comparing the second modelled result with the performance condition; and
as part of the stepwise process continuing training by the processing unit the machine learning algorithm with behavioural data and associated modelled results until the machine learning algorithm has not been significantly changed in the last step of training, and wherein when the training has stopped a final trained machine learning algorithm is provided; and
wherein the final trained machine learning algorithm is configured to be fed with new data to perform one or more of: (1) detect process anomalies, (2) detect device failures, (3) predict the future behaviour of the process, and (4) select the best possible next controller output.

## Patentansprüche

1. System zur Erzeugung eines industriellen Prozessmodells, umfassend:
- eine Eingabeeinheit; und
- eine Verarbeitungseinheit;
wobei die Eingabeeinheit eingerichtet ist zum Empfangen einer Vielzahl von Eingabewertverläufen, die reale Eingabedaten und/oder simulierte Eingabedaten in Bezug auf einen industriellen Prozess umfassen, und wobei die Eingabewertverläufe verwendet werden, um den industriellen Prozess in einer Anzahl von Simulationsläufen zu steuern, um einen anfänglichen Trainingsdatensatz zu erzeugen;
wobei die Verarbeitungseinheit eingerichtet ist zum Implementieren eines Simulators des industriellen Prozesses;
wobei die Verarbeitungseinheit eingerichtet ist zum Implementieren eines maschinellen Lernalgorithmus, der den industriellen Prozess modelliert;
wobei die Verarbeitungseinheit eingerichtet ist zum Trainieren des maschinellen Lernalgorithmus unter Nutzung des anfänglichen Trainingsdatensatzes;
wobei die Verarbeitungseinheit eingerichtet ist zum Nutzen des Simulators, um eine Vielzahl von Verhaltensdaten des industriellen Prozesses zu erzeugen, wobei Verhaltensdaten des industriellen Prozesses für zumindest einige der Vielzahl von Eingabewertverläufen erzeugt werden, wobei die Verarbeitungseinheit eingerichtet ist zum Auswählen der zumindest einigen der Vielzahl von Eingabewertverläufen, wobei die Auswahl der zumindest einigen der Vielzahl von Eingabewertverläufen unter Nutzung einer bestimmten Empfindlichkeit des maschinellen Lernalgorithmus gegenüber zumindest einem Teil der Vielzahl von Verhaltensdaten erfolgt, und wobei die Verhaltensdaten des industriellen Prozesses eines oder mehrere der folgenden umfassen: Prozessdaten, Aktuatordaten und Sollwerte;
wobei die Verarbeitungseinheit eingerichtet ist zum Trainieren des maschinellen Lernalgorithmus in einem schrittweisen Verfahren, umfassend:
Als Teil des schrittweisen Verfahrens ist die Verarbeitungseinheit eingerichtet zum Verarbeiten eines ersten Verhaltensdatensatzes der Vielzahl von Verhaltensdaten mit dem maschinellen Lernalgorithmus, um ein erstes modelliertes Ergebnis zu bestimmen;
Als Teil des schrittweisen Verfahrens ist die Verarbeitungseinheit eingerichtet zur Bestimmung, ob der maschinelle Lernalgorithmus mit den ersten Verhaltensdaten trainiert werden soll oder nicht, wobei die Bestimmung einen Vergleich des ersten modellierten Ergebnisses mit einer Leistungsbedingung umfasst;
Als Teil des schrittweisen Verfahrens ist die Verarbeitungseinheit eingerichtet zum Verarbeiten eines zweiten Verhaltensdatensatzes der Vielzahl von Verhaltensdaten mit dem maschinellen Lernalgorithmus, um ein zweites modelliertes Ergebnis zu bestimmen;
Als Teil des schrittweisen Verfahrens, nach der Bestimmung, ob der maschinelle Lernalgorithmus mit den ersten Verhaltensdaten trainiert werden soll oder nicht, ist die Verarbeitungseinheit eingerichtet zur Bestimmung, ob der maschinelle Lernalgorithmus mit den zweiten Verhaltensdaten trainiert werden soll oder nicht, wobei die Bestimmung einen Vergleich des zweiten modellierten Ergebnisses mit der Leistungsbedingung umfasst;
Als Teil des schrittweisen Verfahrens ist die Verarbeitungseinheit eingerichtet zum Fortsetzen des Trainings des maschinellen Lernalgorithmus mit Verhaltensdaten und zugehörigen modellierten Ergebnissen, bis sich der maschinelle Lernalgorithmus im letzten Trainingsschritt nicht mehr signifikant verändert hat, und wobei, wenn das Training beendet ist, ein endgültig trainierter maschineller Lernalgorithmus bereitgestellt wird; und
wobei der endgültig trainierte maschinelle Lernalgorithmus eingerichtet ist zum Verarbeiten neuer Daten, um eine oder mehrere der folgenden Aufgaben auszuführen: (1) Prozessanomalien erkennen, (2) Geräteausfälle erkennen, (3) das zukünftige Verhalten des Prozesses vorhersagen und (4) den bestmöglichen nächsten Regelausgang auswählen.

2. System nach Anspruch 1, wobei die Vielzahl der Eingabewertverläufe eines oder mehrere der folgenden umfasst: Prozessdaten, Temperaturdaten, Druckdaten, Durchflussdaten, Füllstandsdaten, Spannungsdaten, Stromdaten, Leistungsdaten, Aktuatordaten, Ventildaten, Sensordaten, Steuerungsdaten.

3. System nach einem der Ansprüche 1 - 2, wobei die Bestimmung, ob der maschinelle Lernalgorithmus mit den ersten Verhaltensdaten trainiert werden soll oder nicht, eine Bestimmung der Empfindlichkeit des trainierten maschinellen Lernalgorithmus gegenüber zumindest einem Teil der Vielzahl von Verhaltensdaten umfasst.

4. System nach einem der Ansprüche 1 - 3, wobei die Bestimmung, ob der maschinelle Lernalgorithmus mit den zweiten Verhaltensdaten trainiert werden soll oder nicht, eine Bestimmung der Empfindlichkeit des trainierten maschinellen Lernalgorithmus gegenüber zumindest einem Teil der Vielzahl von Verhaltensdaten umfasst.

5. System nach einem der Ansprüche 1 - 4, wobei die Bestimmung, ob der maschinelle Lernalgorithmus weiter mit den zweiten Verhaltensdaten trainiert werden soll oder nicht, eine Bestimmung der Empfindlichkeit des trainierten maschinellen Lernalgorithmus gegenüber zumindest einem Teil der Vielzahl von Verhaltensdaten umfasst.

6. System nach einem der Ansprüche 4 - 5, wobei die Bestimmung der Empfindlichkeit des trainierten maschinellen Lernalgorithmus gegenüber zumindest einem Teil der Vielzahl von Verhaltensdaten eine Analyse einer Verlustfunktion des trainierten maschinellen Lernalgorithmus in Bezug auf zumindest den Teil der Vielzahl von Verhaltensdaten umfasst.

7. System nach einem der Ansprüche 1 - 6, wobei die Verarbeitungseinheit eingerichtet ist zur Bestimmung des Stopps des Trainings des maschinellen Lernalgorithmus, wobei die Bestimmung eine Bestimmung der Empfindlichkeit des trainierten maschinellen Lernalgorithmus gegenüber zumindest einem Teil der Vielzahl von Verhaltensdaten umfasst.

8. Verfahren zur Erzeugung eines industriellen Prozessmodells, umfassend:
Empfangen einer Vielzahl von Eingabewertverläufen, die reale Eingabedaten und/oder simulierte Eingabedaten in Bezug auf einen industriellen Prozess umfassen, wobei die Eingabewertverläufe verwendet werden, um den industriellen Prozess in einer Anzahl von Simulationsläufen zu steuern, um einen anfänglichen Trainingsdatensatz zu erzeugen;
Implementieren eines Simulators des industriellen Prozesses durch eine Verarbeitungseinheit;
Implementieren eines maschinellen Lernalgorithmus, der den industriellen Prozess modelliert, durch die Verarbeitungseinheit;
Trainieren des maschinellen Lernalgorithmus durch die Verarbeitungseinheit, umfassend die Nutzung des anfänglichen Trainingsdatensatzes;
Erzeugen einer Vielzahl von Verhaltensdaten des industriellen Prozesses durch die Verarbeitungseinheit, wobei Verhaltensdaten des industriellen Prozesses für zumindest einige der Vielzahl von Eingabewertverläufen erzeugt werden, wobei die Verarbeitungseinheit die zumindest einige der Vielzahl von Eingabewertverläufen auswählt, und wobei die Auswahl der zumindest einigen der Vielzahl von Eingabewertverläufen unter Nutzung einer bestimmten Empfindlichkeit des maschinellen Lernalgorithmus gegenüber zumindest einem Teil der Vielzahl von Verhaltensdaten erfolgt, und wobei die Verhaltensdaten des industriellen Prozesses eines oder mehrere der folgenden umfassen: Prozessdaten, Aktuatordaten und Sollwerte;
Trainieren des maschinellen Lernalgorithmus durch die Verarbeitungseinheit in einem schrittweisen Verfahren, umfassend:
als Teil des schrittweisen Verfahrens Verarbeiten eines ersten Verhaltensdatensatzes der Vielzahl von Verhaltensdaten mit dem maschinellen Lernalgorithmus durch die Verarbeitungseinheit, um ein erstes modelliertes Ergebnis zu bestimmen;
als Teil des schrittweisen Verfahrens Bestimmen durch die Verarbeitungseinheit, ob der maschinelle Lernalgorithmus mit den ersten Verhaltensdaten trainiert werden soll oder nicht, wobei die Bestimmung einen Vergleich des ersten modellierten Ergebnisses mit einer Leistungsbedingung umfasst;
als Teil des schrittweisen Verfahrens Verarbeiten eines zweiten Verhaltensdatensatzes der Vielzahl von Verhaltensdaten mit dem maschinellen Lernalgorithmus durch die Verarbeitungseinheit, um ein zweites modelliertes Ergebnis zu bestimmen;
als Teil des schrittweisen Verfahrens nach der Bestimmung, ob der maschinelle Lernalgorithmus mit den ersten Verhaltensdaten trainiert werden soll oder nicht, Bestimmen durch die Verarbeitungseinheit, ob der maschinelle Lernalgorithmus mit den zweiten Verhaltensdaten trainiert werden soll oder nicht, wobei die Bestimmung einen Vergleich des zweiten modellierten Ergebnisses mit der Leistungsbedingung umfasst;
als Teil des schrittweisen Verfahrens Fortsetzen des Trainings des maschinellen Lernalgorithmus mit Verhaltensdaten und zugehörigen modellierten Ergebnissen durch die Verarbeitungseinheit, bis der maschinelle Lernalgorithmus sich im letzten Trainingsschritt nicht mehr signifikant verändert hat, und wobei, wenn das Training beendet ist, ein endgültig trainierter maschineller Lernalgorithmus bereitgestellt wird;
wobei der endgültig trainierte maschinelle Lernalgorithmus eingerichtet ist, mit neuen Daten versorgt zu werden, um eine oder mehrere der folgenden Aufgaben auszuführen: (1) Prozessanomalien erkennen, (2) Geräteausfälle erkennen, (3) das zukünftige Verhalten des Prozesses vorhersagen und (4) den bestmöglichen nächsten Regelausgang auswählen.

## Revendications

1. Système de génération d'un modèle de processus industriel, comprenant :
- une unité d'entrée ; et
- une unité de traitement ;
dans lequel l'unité d'entrée est configurée pour recevoir une pluralité de trajectoires de valeurs d'entrée comprenant des données d'entrée réelles et/ou des données d'entrée simulées relatives à un processus industriel, et dans lequel les trajectoires de valeurs d'entrée sont utilisées pour contrôler le processus industriel dans un certain nombre de simulations afin de générer un ensemble de données d'entraînement initial ;
dans lequel l'unité de traitement est configurée pour mettre en œuvre un simulateur du processus industriel ; dans lequel l'unité de traitement est configurée pour mettre en œuvre un algorithme d'apprentissage automatique qui modélise le processus industriel ;
dans lequel l'unité de traitement est configurée pour entraîner l'algorithme d'apprentissage automatique en utilisant l'ensemble de données d'apprentissage initial ;
dans lequel l'unité de traitement est configurée pour utiliser le simulateur afin de générer une pluralité de données comportementales du processus industriel, où les données comportementales du processus industriel sont générées pour au moins une partie de la pluralité de trajectoires de valeurs d'entrée, où l'unité de traitement est configurée pour sélectionner au moins une partie de la pluralité de trajectoires de valeurs d'entrée, où la sélection d'au moins une partie de la pluralité de trajectoires de valeurs d'entrée comprend l'utilisation d'une sensibilité déterminée de l'algorithme d'apprentissage automatique pour au moins une partie de la pluralité de données comportementales, et où les données comportementales du processus industriel comprennent un ou plusieurs des éléments suivants ; des données de processus, des données d'actionneur et des points de consigne ;
dans lequel l'unité de traitement est configurée pour entraîner l'algorithme d'apprentissage automatique dans le cadre d'un processus par étapes comprenant :
dans le cadre du processus par étapes, l'unité de traitement est configurée pour traiter des premières données comportementales de la pluralité de données comportementales avec l'algorithme d'apprentissage automatique afin de déterminer un premier résultat modélisé ; dans le cadre du processus par étapes, l'unité de traitement est configurée pour déterminer s'il faut entraîner ou non l'algorithme d'apprentissage automatique à l'aide des premières données comportementales, la détermination comprenant une comparaison du premier résultat modélisé avec une condition de performance ;
dans le cadre du processus par étapes, l'unité de traitement est configurée pour traiter des deuxièmes données comportementales de la pluralité de données comportementales avec l'algorithme d'apprentissage automatique afin de déterminer un deuxième résultat modélisé ;
dans le cadre du processus par étapes, après la détermination d'entraîner ou non l'algorithme d'apprentissage automatique à l'aide des premières données comportementales, l'unité de traitement est configurée pour déterminer d'entraîner ou non l'algorithme d'apprentissage automatique à l'aide des deuxièmes données comportementales, la détermination comprenant une comparaison du deuxième résultat modélisé avec la condition de performance ; et
dans le cadre du processus par étapes, l'unité de traitement est configurée pour continuer à entraîner l'algorithme d'apprentissage automatique avec les données comportementales et les résultats modélisés associés jusqu'à ce que l'algorithme d'apprentissage automatique n'ait pas été modifié de manière significative au cours de la dernière étape de l'entraînement, et où, lorsque l'entraînement s'arrête, un algorithme d'apprentissage automatique entraîné final est fourni ; et
dans lequel l'algorithme d'apprentissage automatique entraîné final est configuré pour être alimenté par de nouvelles données afin d'effectuer une ou plusieurs des opérations suivantes : (1) détecter des anomalies de processus, (2) détecter des défaillances du dispositif, (3) prédire le comportement futur du processus, et (4) sélectionner la meilleure sortie possible du contrôleur suivant.

2. Système selon la revendication 1, dans lequel la pluralité de trajectoires de valeurs d'entrée comprend une ou plusieurs des données suivantes : des données de processus ; des données de température ; des données de pression ; des données de débit ; des données de niveau ; des données de tension ; des données de courant ; des données de puissance ; des données d'actionneur ; des données de vanne ; des données de capteur ; des données de contrôleur.

3. Système selon l'une quelconque des revendications 1 et 2, dans lequel la décision d'entraîner ou non l'algorithme d'apprentissage automatique à l'aide des premières données comportementales comprend une détermination de la sensibilité de l'algorithme d'apprentissage automatique entraîné à au moins une partie de la pluralité de données comportementales.

4. Système selon l'une quelconque des revendications 1 à 3, dans lequel la décision d'entraîner ou non l'algorithme d'apprentissage automatique à l'aide des deuxièmes données comportementales comprend une détermination de la sensibilité de l'algorithme d'apprentissage automatique entraîné à au moins une partie de la pluralité de données comportementales.

5. Système selon l'une quelconque des revendications 1 à 4, dans lequel la décision de poursuivre ou non l'entraînement de l'algorithme d'apprentissage automatique à l'aide des deuxièmes données comportementales comprend une détermination de la sensibilité de l'algorithme d'apprentissage automatique entraîné à au moins une partie de la pluralité de données comportementales.

6. Système selon l'une quelconque des revendications 4 et 5, dans lequel la détermination de la sensibilité de l'algorithme d'apprentissage automatique entraîné à au moins une partie de la pluralité de données comportementales comprend une analyse d'une fonction de perte de l'algorithme d'apprentissage automatique entraîné par rapport à au moins la partie de la pluralité de données comportementales.

7. Système selon l'une quelconque des revendications 1 à 6, dans lequel l'unité de traitement est configurée pour déterminer s'il faut arrêter l'entraînement de l'algorithme d'apprentissage automatique, la détermination comprenant une détermination de la sensibilité de l'algorithme d'apprentissage automatique entraîné à au moins une partie de la pluralité de données comportementales.

8. Procédé de génération de modèle de processus industriel, comprenant les étapes suivantes :
recevoir une pluralité de trajectoires de valeurs d'entrée comprenant des données d'entrée réelles et/ou des données d'entrée simulées relatives à un processus industriel, et où les trajectoires de valeurs d'entrée sont utilisées pour contrôler le processus industriel dans un certain nombre de simulations afin de générer un ensemble de données d'entraînement initial ;
mettre en oeuvre, par une unité de traitement, un simulateur du processus industriel ;
mettre en oeuvre, par l'unité de traitement, un algorithme d'apprentissage automatique qui modélise le processus industriel ;
entraîner, par l'unité de traitement, l'algorithme d'apprentissage automatique en utilisant l'ensemble de données d'apprentissage initial ;
générer, par l'unité de traitement, une pluralité de données comportementales de processus industriel, où les données comportementales du processus industriel sont générées pour au moins une partie de la pluralité de trajectoires de valeurs d'entrée, où l'unité de traitement sélectionne au moins une partie de la pluralité de trajectoires de valeurs d'entrée, où la sélection d'au moins une partie de la pluralité de trajectoires de valeurs d'entrée comprend l'utilisation d'une sensibilité déterminée de l'algorithme d'apprentissage automatique pour au moins une partie de la pluralité de données comportementales, et où les données comportementales du processus industriel comprennent un ou plusieurs des éléments suivants : des données de processus, des données d'actionneur et des points de consigne ;
entraîner l'algorithme d'apprentissage automatique, par l'unité de traitement, dans un processus par étapes, ce qui comprend :
dans le cadre du processus par étapes, le traitement, par l'unité de traitement, de premières données comportementales de la pluralité de données comportementales à l'aide de l'algorithme d'apprentissage automatique afin de déterminer un premier résultat modélisé ;
dans le cadre du processus par étapes, la détermination, par l'unité de traitement, s'il convient ou non d'entraîner l'algorithme d'apprentissage automatique à l'aide des premières données comportementales, la détermination comprenant une comparaison du premier résultat modélisé à une condition de performance ;
dans le cadre du processus par étapes, le traitement, par l'unité de traitement, de deuxièmes données comportementales de la pluralité de données comportementales avec l'algorithme d'apprentissage automatique afin de déterminer un deuxième résultat modélisé ;
dans le cadre du processus par étapes, après avoir déterminé s'il faut entraîner ou non l'algorithme d'apprentissage automatique à l'aide des premières données comportementales, la détermination, par l'unité de traitement, s'il faut entraîner ou non l'algorithme d'apprentissage automatique à l'aide des deuxièmes données comportementales, la détermination comprenant de comparer le deuxième résultat modélisé à la condition de performance ; et
dans le cadre du processus par étapes, la poursuite de l'entraînement, par l'unité de traitement, de l'algorithme d'apprentissage automatique à l'aide de données comportementales et des résultats modélisés associés jusqu'à ce que l'algorithme d'apprentissage automatique n'ait pas été modifié de manière significative au cours de la dernière étape de l'entraînement, et où, lorsque l'entraînement s'est arrêté, un algorithme d'apprentissage automatique entraîné final est fourni ; et
dans lequel l'algorithme d'apprentissage automatique entraîné final est configuré pour être alimenté par de nouvelles données afin d'effectuer une ou plusieurs des opérations suivantes : (1) détecter des anomalies de processus, (2) détecter des défaillances du dispositif, (3) prédire le comportement futur du processus, et (4) sélectionner la meilleure sortie possible du contrôleur suivant.
